# EUROPÄISCHE PATENTSCHRIFT

(11) **EP 0 868 750 B1**
(45) Veröffentlichungstag und Bekanntmachung des Hinweises auf die Patenterteilung: **02.04.2003**
(21) Anmeldenummer: 96946175.5
(22) Anmeldetag: 06.12.1996
(51) Int. Cl.: H01L 29/808, H01L 29/812, H01L 29/86

(54) **HALBLEITERANORDNUNGEN ZUR STROMBEGRENZUNG**
CURRENT-LIMITING SEMICONDUCTOR ARRANGEMENT
DISPOSITIF A SEMI-CONDUCTEUR POUR LIMITATION DE COURANT

(30) Priorität: 22.12.1995 DE 19548443
(43) Veröffentlichungstag der Anmeldung: 07.10.1998
(73) Patentinhaber: Infineon Technologies AG, 81669 München (DE)
(72) Erfinder: STEPHANI, Dietrich, D-91088 Bubenreuth (DE); MITLEHNER, Heinz, D-91080 Uttenreuth (DE); WEINERT, Ulrich, D-91074 Herzogenaurach (DE)
(74) Vertreter: Patentanwälte Westphal, Mussgnug & Partner
(86) Internationale Anmeldenummer: DE9602347
(87) Internationale Veröffentlichungsnummer: WO97023911

(56) Entgegenhaltungen:
- WO-A-95/07548
- DE-U- 9 411 601
- FR-E- 92 860
- US-A- 4 454 523
- IEEE ELECTRON DEVICE LETTERS, Bd. edl-6, Nr. 6, Juni 1985, NEW YORK US, Seiten 304-306, XP002031339 P.M. CAMPBELL ET AL.: "Trapezoidal-groove Schottky-gate vertical-channel GaAs FET (GaAs Static Induction Transistor)"

## Beschreibung

Die Erfindung betrifft eine Halbleiteranordnung.

Zum Versorgen eines elektrischen Verbrauchers mit einem elektrischen Nennstrom wird der Verbraucher über ein Schaltgerät an ein elektrisches Versorgungsnetz geschaltet. Beim Einschaltvorgang und auch im Falle eines Kurzschlusses treten im allgemeinen Überströme auf, die deutlich über den Nennströmen liegen. Zum Schutz des elektrischen Verbrauchers müssen die zwischen dem Verbraucher und das Netz geschalteten Schaltgeräte die Überströme und insbesondere Kurzschlußströme rasch erfassen können, auf vorbestimmte Werte begrenzen und anschließend abschalten können. Für diese Funktion sind strombegrenzende Schalter bekannt, die mit mechanischen Schaltern oder auch Halbleiterschaltern gebildet sein können.

Aus DE-A-43 30 459 ist ein strombegrenzender Halbleiterschalter bekannt mit einem ersten Halbleitergebiet eines gegebenen Leitungstyps, dem an voneinander abgewandten Oberflächen jeweils eine Elektrode zugeordnet sind. In dem ersten Halbleitergebiet sind nun zwischen den beiden Elektroden weitere Halbleitergebiete vom entgegengesetzten Leitungstyp voneinander beabstandet angeordnet. Zwischen den einzelnen weiteren Halbleitergebieten sind jeweils Kanalgebiete des ersten Halbleitergebietes gebildet, die senkrecht zu den beiden Oberflächen des ersten Halbleitergebietes gerichtet sind (vertikale Kanäle). Ein vertikaler Stromfluß zwischen den beiden Elektroden wird durch diese Kanalgebiete geführt und dadurch begrenzt. Zur Steuerung des Stromflusses zwischen den beiden Elektroden kann an die entgegengesetzt dotierten Halbleitergebiete in dem ersten Halbleitergebiet eine Gatespannung angelegt werden, durch die der Widerstand der Kanalgebiete gesteuert werden kann.

Aus der DE-U-94 11 601.6 ist ein vertikales Halbleiterbauelement bekannt, das eine erste und eine zweite Elektroden an gegenüberliegenden Seiten eines Halbleiterkörpers zum Anlegen einer Spannung aufweist. In dem n-leitenden Halbleiterkörper sind beabstandet zu den Oberflächen des Halbleiterkörpers stark p-dotierte Zonen angeordnet, zwischen denen sich n-leitende Kanäle in vertikaler Richtung des Halbleiterkörpers erstrecken.

In Campbell, Garwacki, Sears, Menditto und Baliga: "Trapezoidal-Groove Schottky-Gate Vertical-Channel GaAs FET (GaAs Static Induction Transistor), IEEE Electron Device Letters, Vol. EDL-6, No. 6, June 1985, ist ein vertikaler n-Kanal-MOSFET beschrieben, bei dem unterhalb des Source-Kontakts beabstandet zu der Oberfläche des Halbleiterkörpers stark p-dotierte Zonen ausgebildet sind, zwischen denen sich n-leitende Kanäle in vertikaler Richtung des Halbleiterkörpers erstrecken.

Die FR-E-92 860 beschreibt ein vertikales Halbleiterbauelement mit Elektroden an gegenüberliegenden Seiten eines Halbleiterkörpers. Unterhalb einer der Elektroden ist dabei in einem n-leitenden Halbleitergebiet eines Halbleiterkörpers ein p-leitendes Gebiet vorgesehen, das etwa in der Mitte des Bauelements Aussparungen aufweist, in denen sich n-leitende Kanäle in vertikaler Richtung des Halbleiterkörpers erstrecken.

Der Erfindung liegt nun die Aufgabe zugrunde, eine Halbleiteranordnung anzugeben, die zum Schalten von elektrischen Strömen mit Strombegrenzung bei Überströmen eingesetzt werden kann.

Die genannte Aufgabe wird gemäß der Erfindung gelöst mit den Merkmalen des Anspruchs 1. Die Halbleiteranordnung enthält ein erstes Halbleitergebiet eines vorgegebenen Leitungstyps, ein an einer Oberfläche des ersten Halbleitergebiets angeordnetes Kontaktgebiet und ein innerhalb des ersten Halbleitergebietes unterhalb des Kontaktgebietes angeordnetes zweites Halbleitergebiet vom entgegengesetzten Leitungstyp wie das erste Halbleitergebiet. Das zweite Halbleitergebiet ist in allen Richtungen parallel zur Oberfläche des ersten Halbleitergebiets weiter ausgedehnt als das Kontaktgebiet, so daß in dem ersten Halbleitergebiet wenigstens ein Kanalgebiet gebildet ist, das nach unten durch die Verarmungszone des zwischen dem ersten Halbleitergebiet und dem zweiten Halbleitergebiet gebildeten p-n-Übergangs begrenzt ist und in einem Durchlaßzustand einen elektrischen Strom vom Kontaktgebiet oder zum Kontaktgebiet trägt. Das wenigstens eine Kanalgebiet ist somit lateral in dem ersten Halbleitergebiet angeordnet und weist dadurch ein sehr gutes Sättigungsverhalten auf.

Vorteilhafte Ausgestaltungen und Weiterbildungen der Halbleiteranordnung gemäß der Erfindung ergeben sich aus den vom Anspruch 1 abhängigen Ansprüchen.

In einer ersten vorteilhaften Ausführungsform wird das Kanalgebiet auf einer dem zweiten Halbleitergebiet gegenüberliegenden Seite von einer Verarmungszone eines weiteren p-n-Übergangs begrenzt. Dieser p-n-Übergang ist mit dem ersten Halbleitergebiet und wenigstens einem dritten Halbleitergebiet vom entgegengesetzten Leitungstyp wie das erste Halbleitergebiet gebildet. Vorzugsweise ist nun dem dritten Halbleitergebiet eine Steuerelektrode zugeordnet zum Steuern des elektrischen Widerstands des Kanalgebiets durch Anlegen einer Steuerspannung.

In einer anderen Ausführungsform wird das Kanalgebiet auf einer dem zweiten Halbleitergebiet gegenüberliegenden Seite von der Verarmungszone wenigstens eines Schottky-Kontakts begrenzt. Auch in dieser Ausführungsform ist vorzugsweise an dem Schottky-Kontakt eine Steuerspannung anlegbar zum Steuern des elektrischen Widerstands des Kanalgebiets.

Eine weitere Ausführungsform ist dadurch gekennzeichnet, daß an einer von der genannten Oberfläche des ersten Halbleitergebiets abgewandten, weiteren Oberfläche des ersten Halbleitergebiets ein weiteres Kontaktgebiet angeordnet ist. Zwischen diesem Kontaktgebiet und dem Kontaktgebiet an der anderen Oberfläche des ersten Halbleitergebiets kann dann eine Betriebsspannung für die Halbleiteranordnung angelegt werden.

Zur weiteren Erläuterung der Erfindung wird auf die Zeichnung Bezug genommen, in deren
- FIG 1: eine Ausführungsform der Halbleiteranordnung mit einem nach unten durch einen p-n-Übergang begrenzten Kanalgebiet,
- FIG 2: eine Ausführungsform der Halbleiteranordnung mit einem zusätzlichen p-n-Übergang,
- FIG 3: eine Ausführungsform der Halbleiteranordnung mit Steuerelektroden und
- FIG 4: eine Ausführungsform der Halbleiteranordnung mitzusätzlichen Schottky-Kontakten
jeweils schematisch und im Querschnitt dargestellt sind.

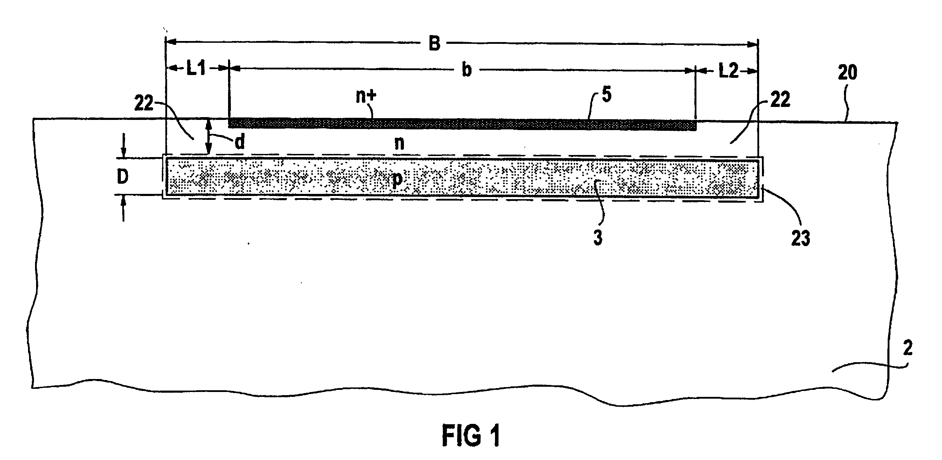

Die in FIG 1 dargestellte Halbleiteranordnung umfaßt ein erstes Halbleitergebiet 2 vom n-Leitungstyp und ein zweites Halbleitergebiet 3 vom p-Leitungstyp. Das erste Halbleitergebiet 2 weist eine vorzugsweise planare Oberfläche 20 auf. Das zweite Halbleitergebiet 3 ist unterhalb der Oberfläche 20 innerhalb des ersten Halbleitergebiets 2 angeordnet und verläuft wenigstens an seiner der Oberfläche 20 des ersten Halbleitergebiets 2 zugewandten Seite lateral, d.h. im wesentlichen parallel zur Oberfläche 20 des ersten Halbleitergebiets 2. Vorzugsweise wird das zweite Halbleitergebiet 3 durch Ionenimplantation von Dotierstoffteilchen in die Oberfläche 20 des ersten Halbleitergebiets 2 erzeugt. Ein gewünschtes Dotierprofil wird durch das Eindringprofil bei der Ionenimplantation mittels der Ionenenergie eingestellt. Die vertikale, d.h. senkrecht zur Oberfläche 20 des ersten Halbleitergebiets 2 gemessene, Ausdehnung D des zweiten Halbleitergebiets 3 ist unkritisch und ergibt sich aus den Ionenenergien bei der Ionenimplantation unter Berücksichtigung etwaiger Implantationsmasken. Zwischen dem ersten Halbleitergebiet 2 und dem entgegengesetzt dotierten zweiten Halbleitergebiet 3 ist ein p-n-Übergang gebildet, dessen Verarmungszone (Raumladungszone) mit 23 bezeichnet ist. Die Verarmungszone 23 des p-n-Übergangs umgibt das gesamte zweite Halbleitergebiet 3. Die laterale Ausdehnung des zweiten Halbleitergebiets 3 parallel zur Oberfläche 20 des ersten Halbleitergebiets 2 im dargestellten Querschnitt ist mit B bezeichnet. An der Oberfläche 20 des ersten Halbleitergebiets 2 ist ein Kontaktgebiet 5 als ohmscher Kontakt vorgesehen. Das ohmsche Kontaktgebiet 5 ist vorzugsweise ein höher dotiertes Halbleitergebiet vom gleichen Leitungstyp wie das erste Halbleitergebiet 2, im dargestellten Ausführungsbeispiel durch n⁺ angedeutet. An das Kontaktgebiet 5 kann mit Hilfe einer nicht dargestellten Elektrode eine elektrische Spannung angelegt werden. Die laterale Ausdehnung des Kontaktgebiets 5 im dargestellten Querschnitt ist mit b bezeichnet. Die laterale Ausdehnung b des Kontaktgebiets 5 ist lateral, d.h. in allen Richtungen parallel zur Oberfläche 20 des ersten Halbleitergebiets 2 kleiner als die laterale Ausdehnung B des zweiten Halbleitergebiets 3. Das zweite Halbleitergebiet 3 und das Kontaktgebiet 5 sind relativ zueinander so angeordnet, daß in einer Projektion senkrecht zur Oberfläche 20 des ersten Halbleitergebiets 2 die Projektion des Kontaktgebiets 5 vollständig innerhalb der Projektion des zweiten Halbleitergebiets 3 liegt. Zwischen dem äußeren Rand des Kontaktgebiets 5 und dem äußeren Rand des ersten Halbleitergebiets 3 ist somit wenigstens ein Kanalgebiet 22 innerhalb des ersten Halbleitergebiets 2 gebildet, dessen laterale Ausdehnungen L1 und L2 auf unterschiedlichen Seiten des Kontaktgebiets 5 gleich oder auch unterschiedlich groß sein können. Es gilt dann L1 + b +L2 = B für die lateralen Ausdehnungen L1, L2, b und B. Das wenigstens eine Kanalgebiet 22 wird nach unten, d.h. zur von der Oberfläche 20 abgewandten Seite hin, von der Raumladungszone 23 des p-n-Übergangs zwischen dem ersten Halbleitergebiet zu einem zweiten Halbleitergebiet 3 begrenzt und nach oben in der dargestellten Ausführungsform von der Oberfläche 20 des ersten Halbleitergebiets 2. Bei Anlegen einer Spannung zwischen dem Kontaktgebiet 5 und einem weiteren, nicht dargestellten Kontaktgebiet an der Oberfläche 20 des ersten Halbleitergebiets 2 oder an einer von der ersten Oberfläche 20 abgewandten weiteren Oberfläche des ersten Halbleitergebiets 2 fließt der elektrische Strom zwischen den beiden Kontaktgebieten somit durch das wenigstens eine Kanalgebiet 22 im ersten Halbleitergebiet 2. Durch die Wahl der geometrischen Abmessung des Kanalgebiets 22 kann der elektrische Widerstand und damit die Stromtragfähigkeit des Kanalgebiets 22 eingestellt werden und somit der elektrische Strom zwischen den beiden Kontaktgebieten in einer gewünschten Weise begrenzt werden. Die vertikale, d.h. senkrecht zur Oberfläche 20 des ersten Halbleitergebiets 2 gemessene, Ausdehnung des Kanalgebiets 22 ist mit d bezeichnet und wird bestimmt durch den Abstand des zweiten Halbleitergebiets 3 von der Oberfläche 20 des ersten Halbleitergebiets 2 und die Ausdehnung der Verarmungszone 23 des zwischen dem ersten Halbleitergebiet 2 und dem zweiten Halbleitergebiet 3 gebildeten p-n-Übergangs. Die Ausdehnung der Raumladungszone 23 des p-n-Übergangs ist dabei abhängig von den Ladungsträgerkonzentrationen in dem ersten Halbleitergebiet 2 und dem zweiten Halbleitergebiet 3 und von der zwischen diesen beiden Halbleitergebieten 2 und 3 anliegenden elektrischen Sperrspannung (Potentialdifferenz in Sperrichtung des p-n-Übergangs). Deshalb kann der elektrische Widerstand im Kanalgebiet 22 auch durch Verändern des Potentials des zweiten Halbleitergebiets 3 durch Anlegen einer Steuerspannung gesteuert werden. Die lateralen Ausdehnungen L1 und L2 werden wie bereits beschrieben durch den Überlapp von Kontaktgebiet 5 und zweitem Halbleitergebiet 3 definiert.

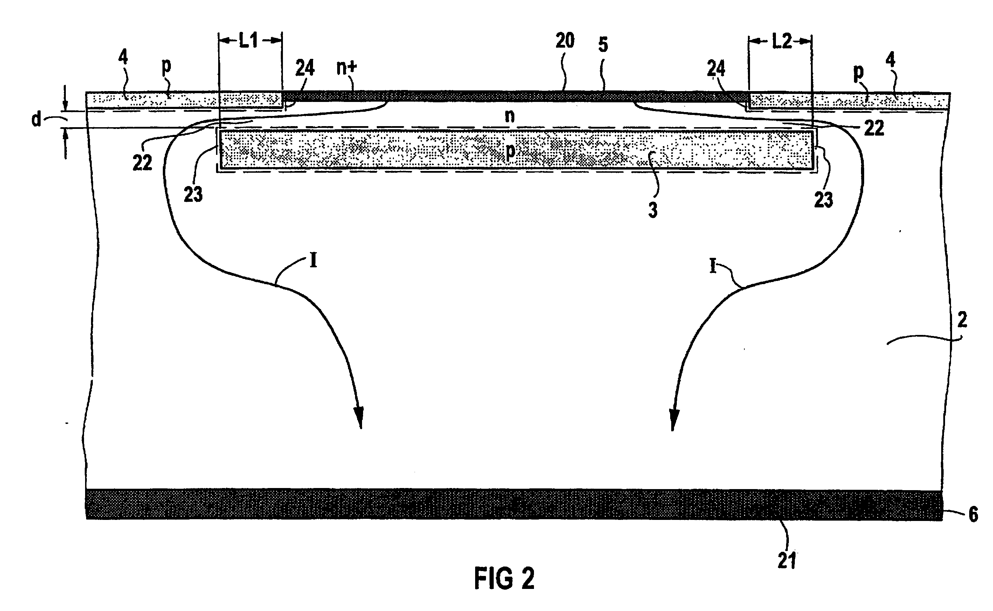

Eine zusätzliche Möglichkeit zur Einstellung der Stromtragfähigkeit des wenigstens einen Kanalgebiets 22 ist in FIG 2 dargestellt. Die Halbleiteranordnung gemäß FIG 2 umfaßt wenigstens ein drittes Halbleitergebiet 4, das p-dotiert und damit vom entgegengesetzten Leitungstyp ist wie das erste Halbleitergebiet 2 und an das erste Halbleitergebiet 2 angrenzt. Das dritte Halbleitergebiet 4 ist lateral, d.h. parallel zur Oberfläche 20 des ersten Halbleitergebiets 2, versetzt zum ersten Halbleitergebiet 3 angeordnet, so daß entlang einer Länge L1 auf der linken Seite und einer Länge L2 auf der rechten Seite in einer Projektion auf die Oberfläche 20 des ersten Halbleitergebiets 2 sich die beiden Halbleitergebiete 3 und 4 überlappen. Somit ist zwischen den beiden p-dotierten Halbleitergebieten 3 und 4 ein lateral sich erstreckendes Kanalgebiet 22 im ersten Halbleitergebiet 2 gebildet, das nach unten wie in FIG 1 durch die Verarmungszone 23 des zwischen dem ersten Halbleitergebiet 2 und dem zweiten Halbleitergebiet 3 gebildeten p-n-Übergangs und nach oben nun durch die Verarmungszone 24 des zwischen dem ersten Halbleitergebiet 2 und dem dritten Halbleitergebiet 4 gebildeten p-n-Übergangs begrenzt ist. In dieser Ausführungsform kann der Stromfluß I zusätzlich durch Einstellen der Ausdehnung der Verarmungszone 24 des weiteren p-n-Übergangs beeinflußt werden. Die Verarmungszone 24 des zwischen dem ersten Halbleitergebiet 2 und dem dritten Halbleitergebiet 4 gebildeten p-n-Übergangs ist abhängig von den Ladungsträgerkonzentrationen in den beiden Halbleitergebieten 2 und 4, den geometrischen Abmessungen des dritten Halbleitergebiets 4 und gegebenenfalls einer am p-n-Übergang anliegenden Spannung. Das Kontaktgebiet 5 grenzt in der dargestellten Ausführungsform unmittelbar an das dritte Halbleitergebiet 4 an, so daß die laterale Ausdehnungen L1 und L2 des Kanalgebiets 22 dem Überlapp der beiden Halbleitergebiete 3 und 4 in der zur Oberfläche 20 orthogonalen Projektion entsprechen. Das Kontaktgebiet 5 und das dritte Halbleitergebiet 4 können aber auch voneinander lateral beabstandet sein. An der von der ersten Oberfläche 20 abgewandten weiteren Oberfläche 21 des ersten Halbleitergebiets 2 ist ein weiteres Kontaktgebiet 6 angeordnet, beispielsweise eine Elektrode. Zwischen dem ersten Kontaktgebiet 5 und dem weiteren Kontaktgebiet 6 wird die Betriebsspannung der Halbleiteranordnung angelegt. In der dargestellten Ausführungsform wird das Kontaktgebiet 5 mit der Kathode und das Kontaktgebiet 6 mit der Anode verbunden. Bei Vertauschung der Leitungstypen der Halbleitergebiete wird die Polarität der Betriebsspannung ebenfalls vertauscht. Die Ausführungsformen gemäß FIG 1 und FIG 2 können insbesondere als passive Strombegrenzer eingesetzt werden.

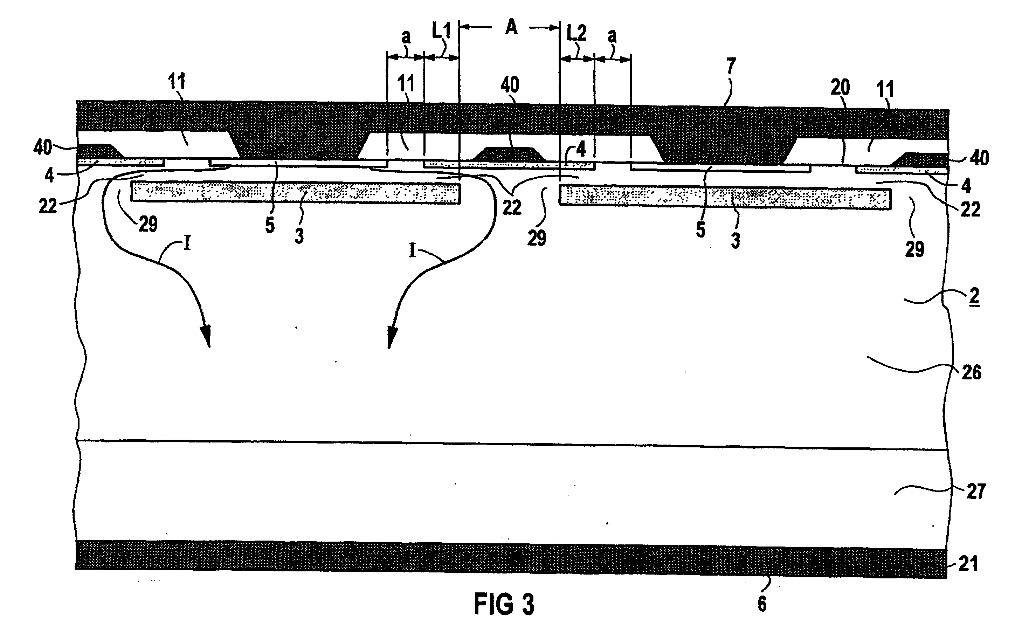

Die FIG 3 zeigt eine Ausführungsform der Halbleiteranordnung mit steuerbarer Strombegrenzung. An der Oberfläche 20 des ersten Halbleitergebiets 2 sind mehrere Kontaktgebiete 5 zueinander beabstandet angeordnet, von denen nur zwei dargestellt sind. Den Kontaktgebieten 5 ist eine gemeinsame Elektrode 7 zugeordnet. Im ersten Halbleitergebiet 2 ist unter den Kontaktgebieten 5 ein zum ersten Halbleitergebiet 2 entgegengesetzt dotiertes zweites Halbleitergebiet 3 vergraben. An der Oberfläche 20 des ersten Halbleitergebiets 2 sind zwischen den Kontaktgebieten 5 jeweils in einem lateralen Abstand a weitere Halbleitergebiete 4 angeordnet, die jeweils entgegengesetzt zum ersten Halbleitergebiet 2 dotiert sind. Die Halbleitergebiete 3 und 4 verlaufen jeweils im wesentlichen lateral zur Oberfläche 20 des ersten Halbleitergebiets 2. Jeweils ein Halbleitergebiet 4 überlappt in einer Projektion entlang einer Richtung senkrecht zur Oberfläche 20 mit jeweils zwei der Halbleitergebiete 3 und jedes Halbleitergebiet 3 mit jeweils zwei der Halbleitergebiete 4. Dadurch sind lateral verlaufende Kanalgebiete 22 in dem ersten Halbleitergebiet 2 gebildet, die wie in FIG 2 nach unten und nach oben jeweils durch die Verarmungszone eines p-n-Übergangₛ begrenzt sind. Die unteren p-n-Übergänge sind zwischen dem ersten Halbleitergebiet 2 und dem zweiten Halbleitergebiet 3 und die oberen p-n-Übergänge zwischen dem ersten Halbleitergebiet 2 und jeweils einem Halbleitergebiet 4 gebildet. Das erste Halbleitergebiet 2 ist in der dargestellten Ausführungsform mit einem Substrat 27 und einer darauf angeordneten, epitaktisch aufgewachsenen Halbleiterschicht 26 gebildet, die vom gleichen Leitungstyp sind. Auf der von der Halbleiterschicht 26 abgewandten Seite des Substrats als zweite Oberfläche 21 des ersten Halbleitergebiets 2 ist wieder eine Elektrode 6 angeordnet. Zwischen der Elektrode 6 und der Elektrode 7 wird die Betriebsspannung der Halbleiteranordnung angelegt. In dem zweiten Halbleitergebiet 3 sind Öffnungen mit jeweils einer lateralen Ausdehnung A gebildet, durch die jeweils ein Kanalgebiet 29 des ersten Halbleitergebiets 2 im wesentlichen vertikal zur Oberfläche 20 verläuft. Jedes Kanalgebiet 29 ist lateral begrenzt durch die nicht dargestellte Verarmungszone des vom ersten Halbleitergebiet 2 und vom zweiten Halbleitergebiet 3 gebildeten p-n-Übergangs. Die laterale Ausdehnung A der Öffnungen in dem zweiten Halbleitergebiet 3 ist so gewählt, daß die zwischen den beiden Kontaktgebieten 6 und 7 anlegbare maximale Sperrspannung zumindest weitgehend der maximalen Volumensperrspannung entspricht, die der p-n-Übergang zwischen den Halbleitergebieten 2 und 3 an der Unterseite des zweiten Halbleitergebiets 3 tragen kann. Dies entspricht einem zumindest weitgehend planaren Verlauf der Äquipotentiallinien im Sperrfall. Typische Werte für die laterale Ausdehnung A der Öffnungen in dem zweiten Halbleitergebiet 3 liegen zwischen 1 µm und 10 µm. Bei Anlegen einer in Durchlaßrichtung gepolten Betriebsspannung fließt zwischen der Elektrode 7 und der Elektrode 6 ein Strom I entlang der dargestellten Pfeile, der zunächst durch die lateralen Kanalgebiete 21 und danach in praktisch vertikaler Richtung zur Oberfläche 20 durch die vertikalen Kanalgebiete 29 im ersten Halbleitergebiet 2 verläuft. Der Stromfluß durch die Kanalgebiete 22 kann durch Steuern des Potentials der Halbleitergebiete 4 gesteuert und insbesondere begrenzt werden. Dazu sind den Halbleitergebieten 4 Steuerelektroden 40 zugeordnet, an die vorzugsweise die gleiche Steuerspannung angelegt wird. Die Steuerelektroden 40 und die gemeinsame Elektrode 7 sind durch eine Isolationsschicht 11 in an sich bekannter Buried-Gate-Technik getrennt. Eine solche Ausführungsform gemäß FIG 3 kann als aktiver Strombegrenzer eingesetzt werden.

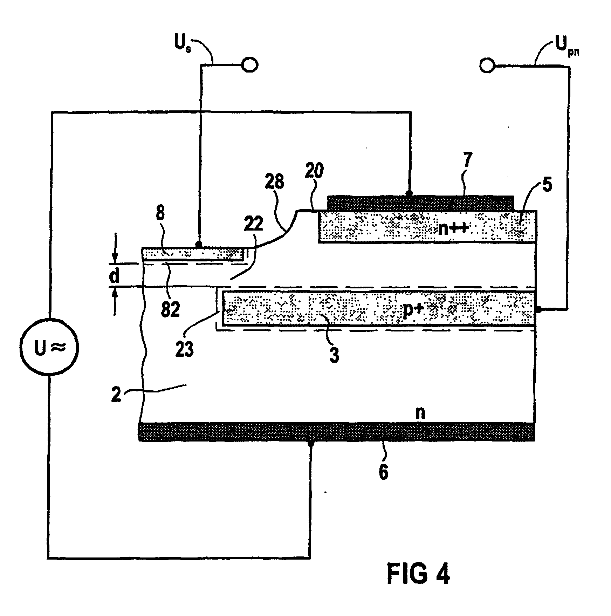

FIG 4 zeigt eine weitere Ausführungsform einer Halbleiteranordnung mit steuerbarer Strombegrenzung. Das Kanalgebiet 22 innerhalb des ersten Halbleitergebiets 2 ist in dieser Ausführungsform nach oben von der Verarmungszone (Sperrschicht) 82 eines Schottky-Kontakts 8 begrenzt und nach unten wieder von der Verarmungszone 23 des p-n-Übergangs zwischen dem ersten Halbleitergebiet 2 und dem vergrabenen Halbleitergebiet 3 begrenzt. Der Schottky-Kontakt 8 ist vorzugsweise an der Oberfläche 20 des ersten Halbleitergebiets 2 angeordnet. Die Ausdehnung der Verarmungszone 82 des Schottky-Kontakts 8 kann durch Verändern einer an dem Schottky-Kontakt anliegenden Schottky-Steuerspannung U_{S} gesteuert werden. Dadurch kann die vertikale Ausdehnung (Tiefe) d des Kanalgebiets 22 und damit dessen Stromtragfähigkeit für einen zwischen dem Kontaktgebiet 5 mit der Elektrode 7 und der Elektrode 6 fließenden Strom gesteuert werden. Die an den beiden Elektroden 6 und 7 anliegende Betriebsspannung der Halbleiteranordnung ist mit U bezeichnet und kann insbesondere eine Wechselspannung sein. Die vertikale Ausdehnung d des Kanalgebiets 22 ist in der dargestellten Ausführungsform zusätzlich durch Abtragen von Halbleitermaterial aus dem ersten Halbleitergebiet 2 beispielsweise durch einen Ätzprozeß eingestellt. Der Schottky-Kontakt 8 ist in der durch den Materialabtrag erzeugten Vertiefung 28 angeordnet und damit gegenüber der ursprünglichen Oberfläche des ersten Halbleitergebiets 2 nach unten versetzt. Eine solche Einstellung der vertikalen Ausdehnung d des Kanalgebiets 22 durch Erzeugen von Vertiefungen oder komplementär durch Erzeugen von Erhöhungen durch zusätzliches Material kann auch bei allen anderen Ausführungsformen vorgenommen werden.

Alle beschriebenen Ausführungsformen der Halbleiteranordnung können in verschiedenen Topologien ausgeführt werden, insbesondere in einem Zelldesign mit Mehrlagenmetallisierung oder auch in einer kammartigen Struktur.

## Patentansprüche

1. Halbleiteranordnung mit
a) einem ersten Halbleitergebiet (2) eines vorgegebenen Leitungstyps,
b) einem an einer Oberfläche (20) des ersten Halbleitergebiets (2) angeordneten Kontaktgebiet (5) und
c) einem zweiten Halbleitergebiet (3), das innerhalb des ersten Halbleitergebiets (2) unterhalb des Kontaktgebiets (5) angeordnet ist und den entgegengesetzten Leitungstyp wie das erste Halbleitergebiet (2) aufweist,
**dadurch gekennzeichnet, dass**
d) sich das zweite Halbleitergebiet (3) als zusammenhängendes Gebiet in allen Richtungen parallel zur Oberfläche (20) des ersten Halbleitergebiets (2) weiter erstreckt als das Kontaktgebiet (5), so daß in dem ersten Halbleitergebiet (2) wenigstens ein laterales Kanalgebiet (22) gebildet ist, das nach unten durch die Verarmungszone (23) des zwischen dem ersten Halbleitergebiet (2) und dem zweiten Halbleitergebiet(3) gebildeten p-n-Übergangs begrenzt ist und in einem Durchlaßzustand einen elektrischen Strom vom Kontaktgebiet (5) oder zum Kontaktgebiet (5) transportiert.

2. Halbleiteranordnung nach Anspruch 1 mit wenigstens einem dritten Halbleitergebiet (4) vom entgegengesetzten Leitungstyp wie das erste Halbleitergebiet (2), wobei zwischen dem dritten Halbleitergebiet (4) und dem ersten Halbleitergebiet (2) ein p-n-Übergang gebildet ist, dessen Verarmungszone (24) das Kanalgebiet (22) auf einer dem zweiten Halbleitergebiet (3) gegenüberliegenden Seite begrenzt.

3. Halbleiteranordnung nach Anspruch 2, bei der benachbart zu dem dritten Halbleitergebiet (4) eine Steuerelektrode (40) zum Steuern des elektrischen Widerstands des Kanalgebietes (22) durch Anlegen einer Steuerspannung angeordnet ist.

4. Halbleiteranordnung nach Anspruch 1, mit wenigstens einem Schottky-Kontakt (8), dessen Verarmungszone (82) das Kanalgebiet (22) auf einer dem zweiten Halbleitergebiet (3) gegenüberliegenden Seite begrenzt.

5. Halbleiteranordnung nach Anspruch 4, bei der an den Schottky-Kontakt (6) eine Steuerspannung (U_{S}) anlegbar ist zum Steuern des elektrischen Widerstands des Kanalgebiets (22).

6. Halbleiteranordnung nach einem der vorhergehenden Ansprüche, bei der an einer von der genannten Oberfläche (20) des ersten Halbleitergebiets (2) abgewandten weiteren Oberfläche (21) des ersten Halbleitergebiets (2) ein weiteres Kontaktgebiet (6) vorgesehen ist und bei der das zweite Halbleitergebiet (3) wenigstens ein im wesentlichen vertikal zur Oberfläche (20) des ersten Halbleitergebiets (2) verlaufendes Kanalgebiet (29) des ersten Halbleitergebiets (2) enthält, durch das in einem Durchlaßzustand ein elektrischer Strom (I) zwischen den beiden Kontaktgebieten (6,7) fließt.

## Claims

1. A semiconductor arrangement having
a) a first semiconductor zone (2) of a predetermined conduction type,
b) a contact zone (5) disposed on one surface (20) of the first semiconductor zone (2) and
c) a second semiconductor zone (3), which is disposed inside the first semiconductor zone (2) beneath the contact zone (5) and has the opposite conduction type to the first semiconductor zone (2),
**characterised in that**
d) the second semiconductor zone (3) as a continuous zone extends further in all directions parallel to the surface of the first semiconductor zone (2) than the contact zone (5), so that in the first semiconductor zone (2) at least one lateral channel zone (22) is formed, which is limited at the bottom by the depletion zone (23) of the p-n junction formed between the first semiconductor zone (2) and the second semiconductor zone (3) and in the conducting state transports an electric current from the contact zone (5) or to the contact zone (5).

2. A semiconductor arrangement according to Claim 1, having at least a third semiconductor zone (4) of the opposite conduction type to the first semiconductor zone (2), wherein a p-n junction is formed between the third semiconductor zone (4) and the first semiconductor zone (2), the depletion zone (24) of which limits the channel zone (22) on a side opposite the second semiconductor zone (3).

3. A semiconductor arrangement according to Claim 2, in which a control electrode (40) is disposed adjacent to the third semiconductor zone (4) to control the electrical resistance of the channel zone (22) by applying a control voltage.

4. A semiconductor arrangement according to Claim 1, having at least one Schottky contact (8), the depletion zone (82) of which limits the channel zone (22) on a side opposite the second semiconductor zone (3).

5. A semiconductor arrangement according to Claim 4, in which a control voltage (Uₛ) can be applied to the Schottky contact (6) to control the electrical resistance of the channel zone (22).

6. A semiconductor arrangement according to one of the preceding Claim, in which another contact zone (6) is provided at another surface (21) of the first semiconductor zone (2) remote from the said surface (20) of the first semiconductor zone (2)and in which the second semiconductor zone (3) contains at least one channel zone (29) of the first semiconductor zone (2) running substantially vertically to the surface (20) of the first semiconductor zone (2) , through which an electric current (I) flows between the two contact zones (6, 7) in the conducting state.

## Revendications

1. Dispositif semi-conducteur comportant
a) une première zone semi-conductrice (2) d'un type de conductivité donné.
b) une zone de contact (5) prévue sur une surface (20) de la première zone semi-conductrice (2) et
c) une seconde zone semi-conductrice (3) prévue à l'intérieur de la première zone semi-conductrice (2) en dessous de la zone de contact (5) et de type de conductivité opposé à celle de la première zone semi-conductrice (2),
**caractérisé en ce que**
d) la zone semi-conductrice (3) constituant une zone cohérente s'étend dans toutes les directions parallèlement à la surface (20) de la première zone semi-conductrice (2) et plus loin que la zone de contact (5) de façon à former dans la première zone semi-conductrice (2) au moins une zone de canal latéral (22) délimitée en dessous par la zone d'appauvrissement (23) de la jonction p-n formée entre la première zone semi-conductrice (2) et la seconde zone semi-conductrice (3) et dans un état passant, un courant est transporté à partir de la zone de contact (5) ou vers la zone de contact (5).

2. Dispositif semi-conducteur selon la revendication 1 comportant au moins une troisième zone semi-conductrice (4) de type de conductivité opposée à celle de la première zone semi-conductrice (2),
entre la troisième zone semi-conductrice (4) et la première zone semi-conductrice (2) on a une jonction p-n dont la zone d'appauvrissement (24) limite la zone de canal (22) sur un côté opposé à celui de la seconde zone semi-conductrice (3).

3. Dispositif semi-conducteur selon la revendication 2 dans lequel au voisinage de la troisième zone semi-conductrice (4) on a une électrode de commande (40) pour commander la résistance électrique de la zone de canal (22) en appliquant une tension de commande.

4. Dispositif semi-conducteur selon la revendication 1 comportant au moins un contact Schottky (8) dont la zone d'appauvrissement (82) limite la zone de canal (22) sur le côté opposé à celui de la seconde zone semi-conductrice (3).

5. Dispositif semi-conducteur selon la revendication 4 dans laquelle on applique une tension de commande (U_{S}) au contact Schottky (6) pour commander la résistance électrique de la zone de canal (22).

6. Dispositif semi-conducteur selon l'une des revendications précédentes dans lequel sur une autre surface (21) à l'opposé de la surface (20) ci-dessus de la première zone semi-conductrice (2), il est prévu dans cette première zone (2) une autre zone de contact (6) et
la seconde zone semi-conductrice (3) comporte au moins une zone de canal (29) de la première zone semi-conductrice (2), cette zone de canal étant essentiellement verticale par rapport à la surface (20) de la première zone semi-conductrice (2).
